Europäisches Patentamt

European Patent Office

Office européen des brevets

(11) Veröffentlichungsnummer: **0 337 329**
**A2**

(12) **EUROPÄISCHE PATENTANMELDUNG**

(21) Anmeldenummer: 89106219.2

(22) Anmeldetag: 07.04.89

(51) Int. Cl.⁴: **C23C 14/14 , C23C 14/24 , C23C 14/54**

(30) Priorität: 12.04.88 DE 3812141

(43) Veröffentlichungstag der Anmeldung:
18.10.89 Patentblatt 89/42

(84) Benannte Vertragsstaaten:
**DE FR GB**

(71) Anmelder: **Siemens Aktiengesellschaft**
**Wittelsbacherplatz 2**
**D-8000 München 2(DE)**

(72) Erfinder: **Willer, Josef, Dr.**
**Hirschplanallee 3**
**D-8042 Oberschleissheim(DE)**

(54) Verfahren zur Herstellung dünner Metallfilme durch Aufdampfen.

(57) Verfahren zur Herstellung dünner Metallfilme durch Aufdampfen in einem Rezipienten (1), wobei über ein Druckmeßgerät (4) der Partialdruck des Wasserdampfes in dem Rezipienten (1) gemessen und über ein angeschlossenes Regelsystem (6) dieser Partialdruck zu Beginn und während des Prozesses des Aufdampfens so eingestellt wird, daß reaktiver Einbau von Sauerstoff in die abgeschiedene Metallschicht (3) so gesteuert erfolgt, daß die in dieser Metallschicht (3) auftretende mechanische Spannung minimiert wird.

FIG 1

EP 0 337 329 A2

## Verfahren zur Herstellung dünner Metallfilme durch Aufdampfen

Dünne Metallfilme, typischerweise 10 nm bis ca. 10 μm, können kostengünstig durch Aufdampfen hergestellt werden. Dieses Herstellungsverfahren findet z.B. Anwendung in der Mikroelektronik, wo die Metallkontakte auf Halbleiterbauelementen aus einem oder mehreren übereinander abgeschiedenen Metallfilmen bestehen. Beim Abscheiden eines solchen Metallfilmes tritt eine innere mechanische Spannung (intrinsischer stress) auf. Dadurch werden die Auswahl der Metalle, die verwendet werden können, und die maximale Schichtdicke eingeschränkt. Die in dem Metallfilm auftretende mechanische Spannung hat insbesondere folgende Nachteile:

1. das Substrat kann sich verwölben oder durchbiegen,

2. die sichere Haftung des Metallfilmes auf der Halbleiteroberfläche ist beeinträchtigt,

3. die elektrischen Eigenschaften des Bauelementes können dadurch verändert sein.

Die auftretende Spannung kann eine Druckspannung (compressive) oder eine Zugspannung (tensile) sein. Daher ist die am häufigsten angewandte Methode, die mechanischen Spannungen zu beherrschen, die gegenseitige Kompensation von Schichten mit alternierend Druck- und Zugspannung. In der Arbeit von G.E. Henlein und W.R. Wagner, J. Appl. Phys. $\underline{54}$, 6395 (1983), wird beschrieben, daß beim Titan-Platin-Schichtaufbau die Schichtdicken so aufeinander abgestimmt werden können, daß die inneren Zugspannungen von Titan durch die inneren Druckspannungen des Platin kompensiert werden.

Beim Verfahren des sogenannten "Sputtern" läßt sich die Spannung der aufzubringenden Metallschicht durch den Druck des Plasmas, in der Regel Argon, steuern. Diese Möglichkeit besteht beim Aufdampfen des Metallfilmes nicht.

Aufgabe der vorliegenden Erfindung ist es, ein Verfahren anzugeben, mit dem sich die innere mechanische Spannung eines Metallfilmes, der durch Aufdampfen hergestellt wird, einstellen läßt.

Diese Aufgabe wird durch das erfindungsgemäße Verfahren mit den Merkmalen des Anspruches 1 gelöst. Weitere Ausgestaltungen ergeben sich aus den weiteren Ansprüchen.

Die vorliegende Erfindung basiert auf der Beobachtung, daß der in der Aufdampfkammer, dem Rezipienten, vorhandene Partialdruck von Wasserdampf einen Einfluß auf die sich in dem aufgedampften Metallfilm einstellende mechanische Spannung besitzt. Das erfindungsgemäße Verfahren lehrt, wie man den Partialdruck eines Zusatzgases im Rezipienten gezielt zur Steuerung der mechanischen Spannung in den aufgedampften Metallfilmen einsetzt. Als Zusatzgas kommt insbesondere Wasserdampf, der üblicherweise immer in gewisser Menge im Rezipienten vorhanden ist, oder Ammoniak ($NH_3$) oder ein Wasserdampf-Ammoniak-Gemisch in Frage. Das erfindungsgemäße Verfahren wird im folgenden mit Wasserdampf als Zusatzgas beschrieben.

Bei niedrigem Wasserdampf-Partialdruck im Rezipienten besitzt die aufgedampfte Metallschicht eine hohe Zugspannung. Diese Zugspannung nimmt mit zunehmendem Wasserdampf-Partialdruck kontinuierlich ab und geht nach einem Nulldurchgang in eine Druckspannung über. Wenn der Aufdampfprozess bei niedrigem Wasserdampf-Partialdruck durchgeführt wird, bewirkt folglich die Zugspannung in dem Metallfilm, daß der Metallfilm sich relativ zu dem Substrat zusammenzieht und das Bauelement deswegen gekrümmt ist, und zwar so, daß auf der Seite des Metallfilmes die konkave, auf der Seite des Substrates die konvexe Krümmung vorliegt. Bei Druckspannung im Metallfilm ist das Bauelement gerade gegensinnig gekrümmt.

Fig. 1 zeigt das Schema eines Aufbaues zur Durchführung des erfindungsgemäßen Verfahrens, wobei einige Zusatzkomponenten aus den weitergehenden Ansprüchen mit einge zeichnet sind.

Fig. 2 zeigt eine Meßkurve, die die mechanische Spannung in Abhängigkeit von dem Wasserdampf-Partialdruck zeigt.

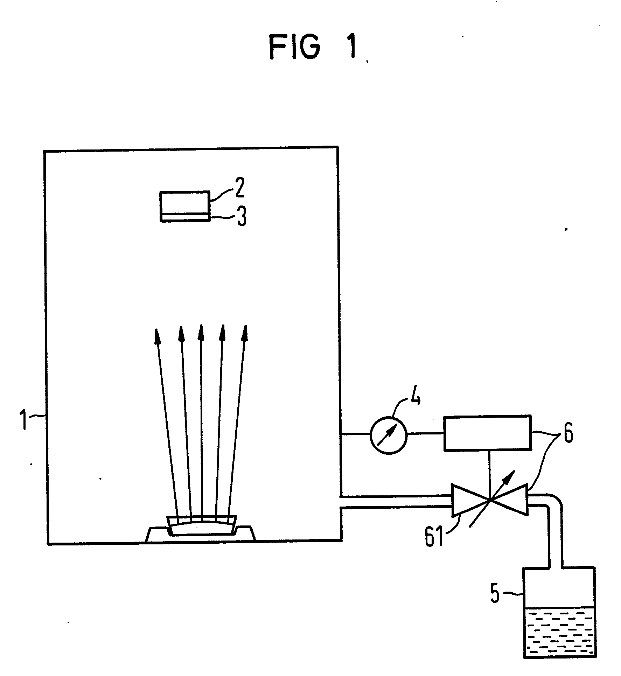

Es folgt eine Beschreibung des Aufbaues nach Fig. 1. In dem Rezipienten 1 ist das Substrat 2, auf das ein Metallfilm aufgedampft werden soll, befestigt. Das aufzudampfende Metall befindet sich dem Substrat gegenüber angeordnet in einem heizbaren Gefäß. Das Aufheizen des Metalles geschieht nach einem der für Aufdampfprozesse bekannten Verfahren. Die austretenden Metallatome schlagen sich als Metallfilm 3 auf dem Substrat 2 nieder. Der Wasserdampf-Partialdruck in dem Rezipienten 1 wird über ein Druckmeßgerät 4 bestimmt. Zweckmäßigerweise ist das Druckmeßgerät dort installiert, wo der Partialdruck des aufzudampfenden Metalles vernachlässigbar ist. Das erfindungsgemäße Verfahren besteht nun darin, z.B. aus einem angeschlossenen Behälter 5 - der z.B. mit Wasser oder $NH_3$ gefüllt ist - das Zusatzgas - Wasserdampf oder Ammoniak - in den Rezipienten 1 einzuleiten und den Partialdruck des Zusatzgases in dem Rezipienten 1 auf einen vorgegebenen konstanten Wert oder auf während des Aufdampfprozesses variierende, aber vorgegebene Werte einzustellen. Das kann z.B. durch ein von Hand betätigtes Dosierventil 61 geschehen. Es ist aber auch möglich, ein Regelsystem 6 vorzusehen, bei dem das Dosierventil 61 über einen mit dem Druckmeßgerät 4 verbundenen Regler oder eine Steuereinheit betätigt wird. Ein programmgesteuertes Regelsystem 6 hat den Vorteil, daß der Wasserdampf-Partialdruck während der Dauer des Aufdampfprozesses in vorgegebener Weise als Funktion der Zeit oder der Metallfilmdicke einreguliert werden kann.

Um eine optimale Haftung des aufzudampfenden Metallfilmes 3 auf dem Substrat 2 bzw. der darauf befindlichen Halbleiterschichtfolge zu gewährleisten, ist es vorteilhaft, wenn zu Beginn des Aufdampfprozesses ein möglichst geringer Wasserdampfanteil im Rezipienten 1 vorhanden ist. Die mit einem Metallfilm zu beschichtenden Teile der Halbleiteroberfläche sollten also möglichst trocken sein. Nachdem eine gewisse Menge Metall aufgedampft worden ist, wird der Partialdruck des Wasserdampfes stetig so weit erhöht, daß ein Wert erreicht wird, der die mechanische Spannung in dem vollständig abgeschiedenen Metallfilm 3 minimiert. Solange der abgeschiedene Metallfilm noch dünn ist, tritt in dieser Metallschicht eine Druckspannung auf (vgl. J. Appl. Phys. 57, 211 bis 215 (1985)). Mit dem Anwachsen der Schichtdicke stellt sich in der Regel eine Zugspannung ein, die kompensiert werden muß.

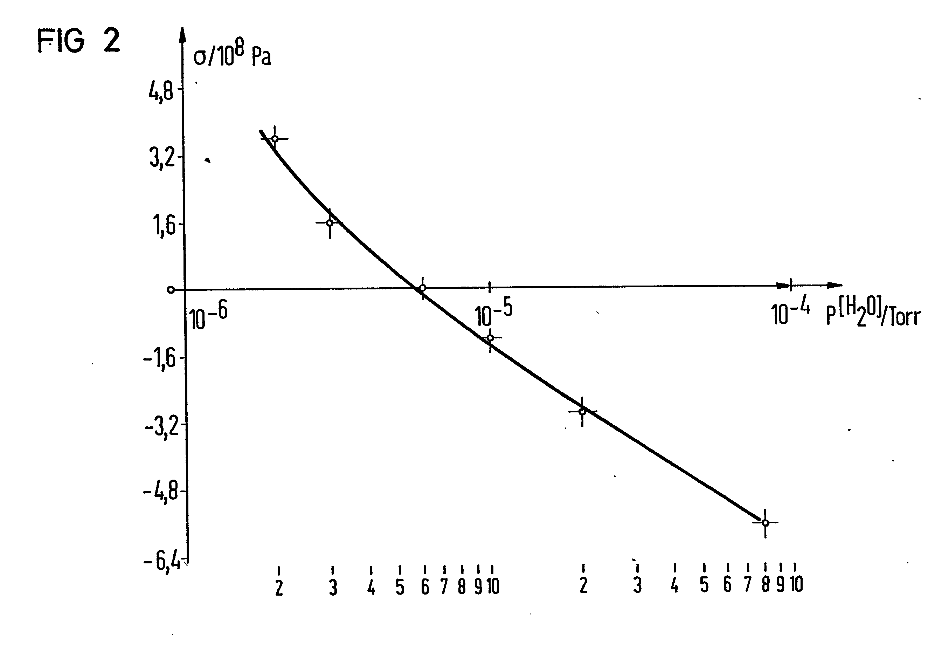

Fig. 2 zeigt eine Meßkurve, bei der über dem Wasserdampf-Partialdruck P im Rezipienten die mechanische Zugspannung (Signal) in dem fertigen Metallfilm aufgetragen ist. Der Wert ist positiv, wenn eine Zugspannung (tensile) vorliegt, und negativ, wenn es sich um eine Druckspannung (compressive) handelt. Das aufgedampfte Metall war Molybdän, das in einer Rate von 500 pm/s aufgedampft worden ist. Die Dicke des Metallfilms betrug 120 nm. Es sind sechs Wertepaare eingetragen, die in dem halblogarithmischen Koordinatensystem mit einer Kurve verbunden sind. Diese Kurve hat streng monoton fallenden Verlauf. Bei kleinen Werten des Wasserdampf-Partialdruckes liegt Zugspannung vor, bei hohen Werten entsprechend Druckspannung. Durch Einstellen des Wasserdampf-Partialdruckes im Bereich des Nulldurchganges dieser Kurve läßt sich die in der fertigen Metallschicht auftretende mechanische Spannung minimieren.

Bezüglich der Abhängigkeit der mechanischen Spannung, die in dem aufgedampften Metallfilm auftritt, von dem Druck des Wasserdampfes ist festgestellt worden, daß aus dem Wasserdampf Sauerstoff bzw. Stickstoff in die abgeschiedene Metallschicht eingebaut wird. Dieser reaktive Einbau von Sauerstoff bzw. Stickstoff beeinflußt erkanntermaßen das Kornwachstum in der Metallschicht. Daher läßt sich das erfindungsgemäße Verfahren für alle Metalle verwenden, die eine hierfür genügend hohe Sauerstoff- bzw. Stickstoffaffinität besitzen. Das gilt insbesondere für die Übergangsmetalle. Metalle, die bevorzugt geeignet sind, sind Molybdän, Titan, Vanadium, Zirkon, Niob, Hafnium, Tantal, Wolfram, Nickel, Aluminium, Mangan, Ruthenium, Rhenium, Osmium, Iridium und Lanthan. Parameter, die für die richtige Einstellung des Wasserdampf-Partialdruckes relevant sind, sind neben dem verwendeten Metall die Schichtdicke des aufzudampfenden Metallfilmes und die Aufdampfrate. Unter Umständen kann es erforderlich sein, nicht mit einem konstanten Wert für den Wasserdampf-Partialdruck zu arbeiten, sondern diesen Wert während des Aufdampfprozesses zu variieren. Der Wasserdampf-Partialdruck liegt bei dem erfindungsgemäßen Aufdampfverfahren typisch zwischen ca. $10^{-6}$ und $10^{-4}$ Torr. Das angeschlossene Wasserreservoir 5 braucht dafür nicht beheizt zu werden, sondern kann auf Raumtemperatur gehalten werden. Das erfindungsgemäße Verfahren umfaßt alle Ausgestaltungen und technischen Realisierungen für die Regelung des Wasserdampf-Partialdruckes in dem Rezipienten 1. Anders als im Stand der Technik ist es bei dem erfindungsgemäßen Verfahren möglich, eine spannungsfreie homogene Metallschicht durch Aufdampfen zu erzeugen.

## Ansprüche

1. Verfahren zur Herstellung dünner Metallfilme durch Aufdampfen in einem Rezipienten,
**dadurch gekennzeichnet,**
daß der Partialdruck eines Zusatzgases in dem Rezipienten während der Dauer des Aufdampfens so eingestellt wird, daß die in der aufgedampften Metallschicht auftretende mechanische Spannung innerhalb eines vorgegebenen Bereiches liegt.

2. Verfahren nach Anspruch 1,
**dadurch gekennzeichnet,**
daß über ein Druckmeßgerät der Partialdruck des Zusatzgases in dem Rezipienten gemessen wird,
daß eine Einrichtung zum Einstellen dieses Partialdruckes vorhanden ist und
daß über diese Einrichtung zu Beginn und während des Prozesses des Aufdampfens der Partialdruck des Zusatzgases so eingestellt wird, daß die in dieser abgeschiedenen Metallschicht auftretende mechanische Spannung innerhalb eines vorgegebenen Bereiches liegt.

3. Verfahren nach Anspruch 2,
**dadurch gekennzeichnet,**
daß das Zusatzgas aus einem an den Rezipienten 1 angeschlossenen Behälter 5 eingeleitet wird und daß die Einrichtung zum Einstellen des Partialdruckes des Zusatzgases ein Dosierventil 61 ist.

4. Verfahren nach Anspruch 2,
**dadurch gekennzeichnet,**
daß die Einrichtung zum Einstellen des Partialdruckes des Zusatzgases ein mit dem Druckmeßgerät 4 verbundenes Regelsystem 6 ist.

5. Verfahren nach einem der Ansprüche 1 bis 4,
**dadurch gekennzeichnet,**
daß das aufzudampfende Metall eine Sauerstoffaffinität besitzt, die eine vorgegebene Mindesteffizienz bei der Anwendung des Verfahrens sicherstellt.

6. Verfahren nach einem der Ansprüche 1 bis 5,
**dadurch gekennzeichnet,**
daß der Partialdruck des Zusatzgases während des Aufdampfens der Metallschicht konstant gehalten wird.

7. Verfahren nach einem der Ansprüche 1 bis 6,
**dadurch gekennzeichnet,**
daß das aufzudampfende Metall ein Übergangsmetall ist.

8. Verfahren nach einem der Ansprüche 1 bis 6,
**dadurch gekennzeichnet,**
daß das aufzudampfende Metall Molybdän, Titan, Vanadium, Zirkon, Niob, Hafnium, Tantal, Wolfram, Nickel oder Aluminium enthält.

9. Verfahren nach einem der Ansprüche 1 bis 6,
**dadurch gekennzeichnet,**
daß das aufzudampfende Metall Mangan, Ruthenium, Rhenium, Osmium, Iridium oder Lanthan enthält.

10. Verfahren nach einem der Ansprüche 1 bis 6,
**dadurch gekennzeichnet,**
daß zum Aufdampfen Molybdän verwendet wird, daß eine Metallschicht mit einer Schichtdicke von weniger als 150 nm aufgedampft wird, daß die Aufdampfrate während des Prozesses 1 nm/s nicht übersteigt und
daß der Partialdruck des Zusatzgases zu Beginn des Aufdampfens zwischen $4 . 10^{-4}$ Pa und $2,5 . 10^{-3}$ eingestellt und während des Aufdampfens in diesem Bereich gehalten wird.

11. Verfahren nach einem der Ansprüche 1 bis 10,
**dadurch gekennzeichnet,**
daß vor Beginn des Aufdampfens der Partialdruck des Zusatzgases auf weniger als $1,3 . 10^{-4}$ Pa eingestellt wird und während des Aufdampfprozesses der Partialdruck des Zusatzgases so weit erhöht wird, daß bei vorgegebener Schichtdicke der aufzudampfenden Metallschicht und vorgegebener Aufdampfrate die mechanische Spannung der aufgedampften Metallschicht innerhalb eines vorgegebenen Bereiches liegt.

12. Verfahren nach einem der Ansprüche 1 bis 11,
**dadurch gekennzeichnet,**
daß das Zusatzgas Wasserdampf ist.

13. Verfahren nach einem der Ansprüche 1 bis 11,
**dadurch gekennzeichnet,**
daß das Zusatzgas Wasserdampf enthält.

14. Verfahren nach einem der Ansprüche 1 bis 11,
**dadurch gekennzeichnet,**
daß das Zusatzgas Ammoniak enthält.

# FIG 1

FIG 2